Europäisches Patentamt

European Patent Office

Office européen des brevets

(19)

(11) Numéro de publication: **0 143 040**
**B1**

(12) **FASCICULE DE BREVET EUROPEEN**

(45) Date de publication du fascicule du brevet:
01.06.88

(51) Int. Cl.⁴: **H 01 L 33/00, H 01 S 3/06**

(21) Numéro de dépôt: **84402179.0**

(22) Date de dépôt: **30.10.84**

(54) **Dispositif optique de concentration du rayonnement lumineux émis par une diode électroluminescente, et diode électroluminescente comportant un tel dispositif.**

(30) Priorité: **04.11.83 FR 8317583**

(43) Date de publication de la demande:
**29.05.85 Bulletin 85/22**

(45) Mention de la délivrance du brevet:
**01.06.88 Bulletin 88/22**

(84) Etats contractants désignés:
**DE GB NL SE**

(56) Documents cités:
**EP - A - 0 014 762**
**EP - A - 0 017 374**
**US - A - 3 414 733**
**US - A - 3 523 720**
**US - A - 4 079 404**

**APPLIED OPTICS, vol. 13, no. 1, janvier 1974, pages 89-94, New York, US; L.G. COHEN et al.: "Microlenses for coupling junction lasers to optical fibers"**
**Idem**
**IEEE TRANSACTIONS ON ELECTRON DEVICES, vol. ED-29, no. 5, mai 1982; pages 876-883, IEEE, New York, US; A.J. SPRINGTHORPE et al.: "High radiance Burrus LED's with integral 45o mirrors"**

(73) Titulaire: **THOMSON-CSF, 173, Boulevard Haussmann, F-75379 Paris Cédex 08 (FR)**

(72) Inventeur: **Mesquida, Guy, THOMSON-CSF SCPI 173, bld Haussmann, F-75379 Paris Cédex 08 (FR)**

(74) Mandataire: **Taboureau, James et al, THOMSON-CSF SCPI 19, avenue de Messine, F-75008 Paris (FR)**

ACTORUM AG

## Description

La présente invention concerne un dispositif optique de concentration de la lumière émise par une diode électroluminescente, ce dispositif étant intégré à la diode électroluminescente, et réalisé dans l'une des couches de matériau semi-conducteur constitutif de la diode. Il est caractérisé en ce qu'il comporte, en surface de la diode, au moins une lentille en demi-tore, entourant une lentille centrale, ledit tore formant un anneau complet dans le plan de la surface de la diode, et étant coupé dans le sens de son épaisseur. L'invention concerne également la diode électroluminescente à laquelle est associée ce dispositif optique.

L'invention s'applique aux diodes électroluminescentes de façon générale, quelles soient du type à émission par le dessus, c'est-à-dire par la face opposée au substrat, mieux connues sous leur appellation anglaise «top emitting», ou quelles soient du type «Burrus», c'est-à-dire à émission à travers un trop pratiqué dans le substrat, la diode étant inversée par rapport à son substrat, et soudée sur son embase par ses couches épitaxiées, et non plus, comme c'est le cas général, par son substrat. C'est pourquoi la structure interne de la diode ne sera pas détaillée dans la description de l'invention, car elle n'est pas concernée par l'invention.

Cependant, il convient de préciser que l'invention s'applique aux diodes électroluminescentes réalisées dans des matériaux de la famille III–V et en particulier les alliages à base de gallium et d'arsenic, tel que $Ga As$ et $Ga_x Al_{1-x} As$ qui sont les plus courants, sans pour autant être limitatifs.

Le problème auquel l'invention apporte une solution est celui du couplage optique entre une diode électroluminescente et une fibre optique, pour toutes les installations de télécommunications, informatique ou bureautique utilisant des interfaces par fibre.

Il est connu que les diodes électroluminescentes possèdent un rendement quantique externe très faible, d'une manière générale de l'ordre de 2%. La puissance optique recueillie dans un diagramme d'émission Lambertien est en effet limitée par la réflexion totale, à l'intérieur du matériau semi-conducteur, qui se produit à l'interface entre le corps semi-conducteur de la diode et l'air.

La solution efficace à ce problème de perte de puissance consiste à adapter une lentille de sortie en surface de la diode. Ainsi l'adaptation des indices des différents milieux, et la forme de l'optique permettent de récupérer une quantité plus importante de lumière émise par la couche active de la diode électroluminescente.

Mais, parmi d'autres, l'un des problèmes est celui des dimensions du dispositif optique adapté à la diode. La limitation de l'épaisseur des couches que l'on peut épitaxier limite le rayon des lentilles que l'on peut tailler dans ces couches, donc la quantité de lumière récupérée par chaque lentille: une lentille de grand diamètre récupère davantage de lumière mais nécessite une couche épaisse, or il n'est pas possible de réaliser des couches supérieures à 20 µm d'épaisseur environ. Pour obtenir un faisceau lumineux plus intense à l'extrémité de la fibre optique, il a été proposé d'associer plusieurs lentilles côte à côte, correspondant à autant de zones émissives dans le corps de la diode. Mais l'association de lentilles, circulaires, n'est pas optimale: dans le plan supérieur de la diode, plan dans lequel sont accolées les lentilles, une fraction importante de la surface n'est pas utilisée, sous forme des triangles curvilignes insérés entre les lentilles.

Selon l'invention une diode électroluminescente comporte, sur la surface par laquelle sort la lumière, une lentille hémisphérique centrale et, entourant celle-ci, au moins une seconde lentille plan-convexe en forme de tore, ce tore étant coupé selon un plan parallèle au plan de la surface par laquelle sort la lumière. L'aire occupée par le dispositif optique est meilleure, par rapport à l'aire de la diode, et les surfaces non utilisées sont limitées aux distances de garde entre lentilles, nécessaires au cours de la fabrication desdites lentilles.

La diode électroluminescente associée à un tel dispositif optique comporte soit une zone émissive unique, recouverte par la lentille centrale et les lentilles toriques, soit une zone émissive centrale correspondant à la lentille centrale, et autant de zones émissives en forme d'anneau qu'il y a de lentilles en forme de tore.

De façon plus précise, l'invention concerne un dispositif optique de concentration du rayonnement lumineux émis par une diode électroluminescente; comportant au moins une zone émissive définie dans la couche active de ladite diode, une lentille hémisphérique, centrée par rapport à la zone émissive et réalisé dans la couche de contact qui supporte une métallisation de prise de contact électrique et qui est en un matériau semi-conducteur transparent à la longueur d'onde du rayonnement émis par la diode et au moins une lentille hémitorique plan-convexe, concentrique avec la lentille hémisphérique centrale.

L'invention sera mieux comprise grâce à la description détaillée qui suit, laquelle explique une forme de réalisation de diodes électroluminescentes munies d'un système optique, et s'appuie sur les figures jointes en annexe qui représentent:

– figure 1: vue en coupe d'une diode électroluminescente à émission par la face supérieure, munie d'une lentille, selon l'art connu,

– figure 2: vue en coupe d'une diode électroluminescente munie d'un réseau de lentilles selon l'art connu,

– figure 3: disposition des lentilles de la figure précédente, vue en plan,

– figure 4: disposition optimisée de lentilles, constituant une première étape à l'invention,

– figure 5: diagramme de réfraction d'un rayon lumineux dans une lentille semi-cylindrique,

– figure 6: vue en plan d'une diode électroluminescente munie du dispositif optique selon l'invention,

– figure 7: vue de trois quart dans l'espace d'une diode électroluminescente, coupée, et munie du dispositiv optique selon l'invention,

– figure 8: première étape du procédé de fabrication du dispositif optique,

– figure 9: seconde étape du procédé de fabrication du dispositif optique de la diode électroluminescente selon l'invention.

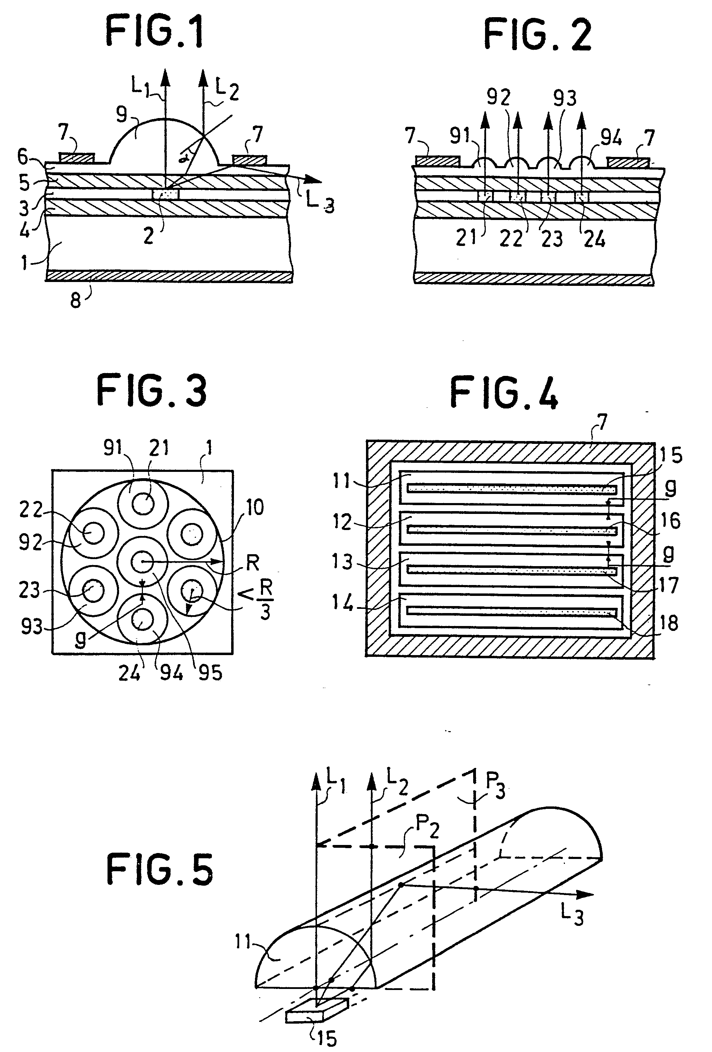

La figure 1 représente une vue en coupe d'une diode électroluminescente à émission par la face supérieure (top emitting) munie d'une lentille, telle qu'elle est décrite par exemple dans EP-A-0 101 368 déposée par la demanderesse.

Une telle diode électroluminescente comporte ce que l'on conviendra par la suite d'appeler le corps de la diode, et dont le détail précis n'a pas lieu d'être donné car il sort du domaine de l'invention. Ce corps comprend au moins un substrat 1 et une zone émissive 2 comprise dans une couche active 3, délimitée par deux couches de confinement 4 et 5. Une couche de contact 6, déposée sur la face opposée à celle du substrat 1, supporte le contact ohmique 7 qui permet d'appliquer une tension à la diode électroluminescente, l'autre contact 8 étant pris sur le substrat. Dans la couche de contact 6, qui était à l'origine plus épaisse, a été taillée une lentille 9 qui permet de récupérer les rayons lumineux issus de la zone émissive 2, de façon à augmenter la puissance optique transmise à la fibre optique non représentée sur cette figure, mais qui est à proximité de la lentille 9. Les rayons lumineux tels que L1 qui sont orthogonaux au plan de sortie de la diode électroluminescente sont transmis sans difficulté. Les rayons lumineux tels que L2 sont transmis dans la limite où l'angle α, qu'ils forment dans le matériau semiconducteur avec l'orthogonale au plan d'interface matériau semi-conducteur et air, est inférieur à 16° 4′, pour un matériau tel que Ga Al As dont l'indice de réfraction est de l'ordre de n = 3,5, pour n = 1 pour l'air. Enfin les rayons lumineux tels que L3, très inclinés par rapport à l'orthogonale au plan d'émission, atteignent l'interface matériau semiconducteur-air avec un angle α supérieur à 16° 4′, ils sont réfléchis et perdus puisqu'ils ne sortent pas de la diode électroluminescente.

Les dimensions de l'optique, c'est-à-dire le rayon de la lentille 9, doivent être conséquentes pour assurer un gain en puissance suffisant sans trop augmenter le courant de fonctionnement du composant, car l'augmentation de la densité de courant dans la zone émissive 2 fait chauffer la diode électroluminescente. De ce fait, la couche de matériau, dans laquelle doit être gravée l'optique, doit être épaisse, de façon à pouvoir graver une lentille 9 de rayon important. Or il est extrêmement difficile d'obtenir, technologiquement, des doubles hétérostructures de type diodes électrolumincentes avec des couches finales en Ga Al As d'épaisseur supérieure à quelques dizaines de microns, 20 microns étant une moyenne représentative de la réalité.

D'autre part, les technologies collectives de réalisation d'optique intégrée dans des couches de matériaux sont d'autant plus fiables et plus reproductibles que les dimensions de ces optiques sont petites. Ce sont donc là deux difficultés qui s'ajoutent pour s'opposer à ce que la lentille de sortie d'une diode électroluminescente soit de dimensions importantes.

C'est pour pallier à ces difficultés de couches épaisses, impossibles à réaliser pour obtenir une surface optique conséquente, que la demanderesse a proposé, dans la Demande de Brevet précitée, de répartir la surface émissive de la diode en une pluralité de petites surfaces émissives 21, 22, 23 et 24, sur la figure 2, à chaque surface émissive étant associée une lentille dans la surface de contact, soit les quatre lentilles 91, 92, 93 et 94 pour les quatre surfaces émissives citées, sans que ce nombre ne soit limitatif.

La solution présentée en figure 2 a donc pour avantage de ne nécessiter qu'une épaisseur possible de la dernière couche de fabrication de la diode, c'est-à-dire une épaisseur dans laquelle il reste possible de tailler des lentilles 91 à 94: quelques dizaines de micromètres facilement réalisables par épitaxie. Dans cette couche est gravée par une méthode collective et bien contrôlable la série des lentilles de surface de relativement faible diamètre permettant le transfert de la lumière vers une fibre optique.

L'idée qui préside à la réalisation d'une diode électroluminescente selon la figure 2 est donc la répartition homogène de la zone émettrice en plusieurs petites zones élémentaires 21, 22, 23 et 24, de manière à intégrer plus facilement au-dessus de chacune d'elle une lentille gravée directement dans la structure, par une technique d'usinage collectif. Cette idée s'applique aux diodes à émission de surface du type top emitting ou aux diodes «Burrus». On sait en effet que la diode «Burrus» possède un avantage certain sur la diode top emitting: son meilleur refroidissement. Soudée sur son support par le côté des couches épitaxiales, la dissipation de chaleur s'effectue plus facilement vers le boîtier dans une diode «Burrus» que dans le cas d'une diode à émission par le dessus.

Cependant la densité de lentilles circulaires ne correspond pas à une optimisation de la récupération des rayons lumineux par dispositif optique. La figure 3, qui représente une vue en plan de la figure 2, montre la disposition des lentilles dans la diode électroluminescente et permettra de mieux comprendre que ce système n'est pas encore optimisé.

Soit 1 le substrat qui porte une diode électroluminescente, sur laquelle, uniquement à titre d'exemple et afin de ne pas surcharger la figure, sont représentées 7 zones émissives 21, 22, 23... etc. associées à 7 lentilles 91, 92, 93... etc. réparties en une couronne de 6 lentilles autour d'une lentille centrale. Cette structure s'inscrit dans un cercle 10 de rayon R, qui au maximum s'inscrit dans le carré du substrat supportant la diode. Puisque l'exemple choisi prend une couronne de lentilles 91, 92... autour d'une lentille centrale 95, le rayon de ces lentilles élémentaires est au maximum égal à R/3. La surface occupée par 7 lentilles élémentaires de rayon R/3, à l'intérieur d'un cercle de rayon R est égal à 78% de la surface du grand cercle: on ne peut donc au maximum récupérer que 78% de la lumière émise par la diode, si l'on admet que cette lumière sort par toute sa surface supérieure.

Mais en outre, la réalisation des diodes nécessite des opérations de masquage, et il est connu qu'entre deux motifs dans un masque en résine il est nécessaire de laisser une garde g, pour éviter que les deux motifs de résine ne fusionnent en un seul par les forces de capilarité. Ainsi, si R est le rayon du cercle dans lequel sont inscrites les lentilles, celles-ci ont un rayon qui est au maximum R/3−g, R/3 étant lié au fait que dans l'exemple pris il n'y a qu'une seule couronne de lentilles autour de la lentille centrale. Un exemple permettra de voir qu'elle est l'importance de la perte qui est encore réalisée. Si la fibre optique à laquelle doit être associée la diode électroluminescente a un rayon égal à 50 μm, les lentilles élémentaires ne peuvent avoir qu'un rayon égal à 50/3 μm, moins la distance de garde qui pour les opérations de masquage courantes peut être prise égale à g = 5 μm, c'est-à-dire R/10. Un calcul simple permet d'aboutir au résultat suivant: les 7 lentilles élémentaires occupent 336/900 de la surface du cercle $\pi R^2$, ou encore la présence de la garde g nécessaire à la réalisation des lentilles élémentaires abaisse le rendement ou la densité des lentilles en surface de la diode à 37,42% de la surface possible.

Par ailleurs, et en conséquence, la limitation de surface des lentilles élémentaires telles que 91 conduit à travailler avec de fortes densités d'injection par zones émissives telle que 21, de façon à obtenir plus de puissance lumineuse, mais conduit à un échauffement de la diode électroluminescente.

La figure 4 représente une première étape, correspondant à la mise au point de l'invention.

Supposons le substrat 1 de la diode électroluminescente de mêmes dimensions que les substrats des diodes électroluminescentes représentées sur les figures précédentes. Dans le carré de ce substrat, on peut inscrire un cercle 10 de rayon R de même dimension que celui défini en figure 3, ce cercle entrant à l'intérieur de la métallisation de prise de contact 7 qui est obligatoirement déposée à la surface d'une diode électroluminescente. Mais au lieu de réaliser des zones émissives circulaires telles que 21, 22... associées à des lentilles hémisphériques telles que 91, 92..., la diode électroluminescente comporte au moins une zone émissive en forme de ruban et une lentille ayant un rayon de courbure fini dans un plan orthogonal au ruban de la zone émissive, et un rayon de courbure infini dans un plan tangent au même ruban. Les lentilles hémicylindriques sont un premier cas de figure, et les lentilles hémicylindriqus 11, 12, 13, 14 couvrent la plus grande surface possible de l'aire disponible à l'intérieur de la métallisation de la prise de contact. 7. A ces lentilles cylindriques correspondent des zones émissives 15, 16, 17, 18 réalisées dans la couche active de la diode électroluminescente, ces zones émissives étant centrées par rapport aux lentilles cylindriques 11, 12, 13...

Une telle disposition permet d'occuper à la surface du corps de la diode électroluminescente une aire beaucoup plus importante, puisqu'il suffit d'avoir un espace de garde entre chacune des lentilles cylindriques, mais qu'il n'y a plus l'équivalent des triangles curvilignes décrits en figure 3. En outre les zones émissives 15, 16, 17, 18 ayant au total une surface plus importante que les zones émissives circulaires telle que 21, une densité d'injection surfacique moindre que dans le cas précédent de lentilles circulaires permet de moins faire chauffer la diode électroluminescente.

Toutefois, ainsi que le montre la figure 5 cette disposition des zones émissives et des lentilles n'est pas encore complètement optimisée.

Considérons, sur la figure 5, le rayonnement lumineux issu d'un élément de zone émissive 15, en direction d'une lentille hémicylindrique 11. Un premier rayon lumineux L1, qui frappe la face plane de la lentille hémicylindrique sous un angle orthogonal, est directement transmis à l'extérieur vers la fibre optique. Un second rayon L2, qui se trouve dans un plan P2 perpendiculaire à l'axe principal de la lentille hémicylindrique 11, est dévié par cette lentille et récupéré par la fibre optique, sous la seule condition que l'angle d'incidence du rayon L2 à l'interface entre la lentille 11 et l'air ambiant soit inférieure à 16° 4'. Un troisième rayon lumineux L3, émis par l'élément émissif 15 dans un plan P3 parallèle à l'axe principal de la lentille hémicylindrique 11 peut être récupéré en direction de la fibre optique, si son angle d'incidence est inférieur à 16° 4' mais peut également être perdu si, comme cela est représenté sur la figure 5, il est trop oblique et a un angle d'incidence, à la surface de la lentille hémicylindrique, supérieure à 16° 4'.

Une telle disposition basée sur des lentilles hémicylindriques permet donc de récupérer davantage de surface utile à la surface de la diode, et permet également d'avoir des zones émissives 15, 16... qui travaillent sous une plus faible densité d'injection pour obtenir la même émission lumineuse. Cependant cette géométrie n'évite pas de perdre une partie du rayonnement qui est réfléchi selon l'axe principal des lentilles, comme c'est le cas pour le rayon L3 de la figure 5.

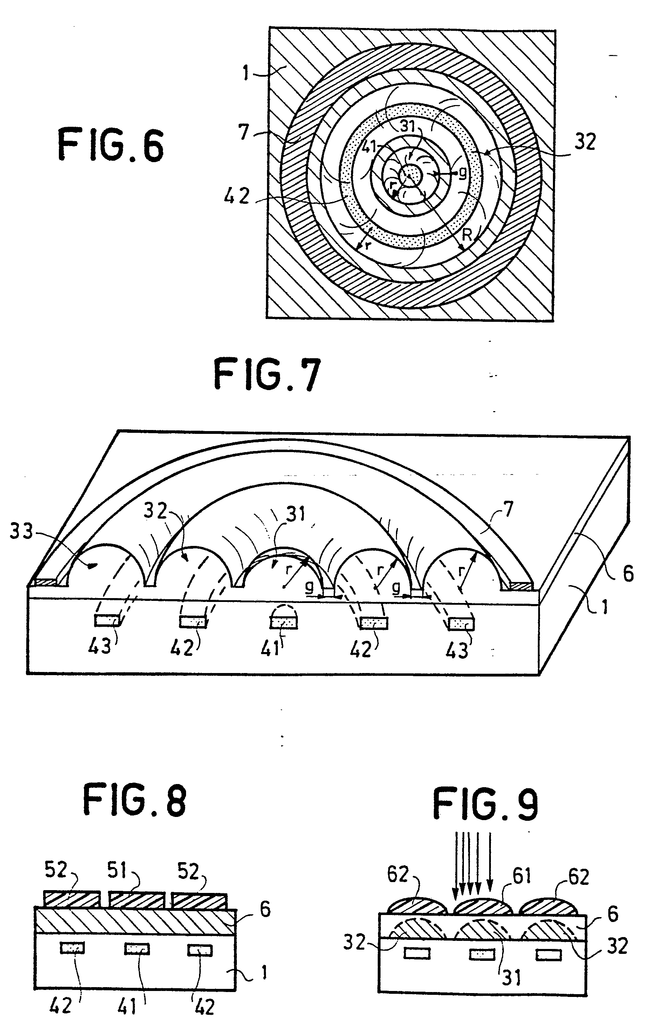

La figure 6 représente une vue en plan de la surface supérieure d'une diode électroluminescente munie du dispositif optique selon l'invention.

Soit un corps 1 de diode élecroluminescente, dont la surface opposée à celle du substrat porte une métallisation de prise de contact 7. Dans la couche supérieure de cette diode électroluminescente sont taillées au moins une lentille hémisphérique centrale 31 et au moins une lentille semitorique 32, concentrique à la lentille centrale 31. Par lentille semitorique 32, il faut entendre que la lentille 32 forme un cercle complet autour de la lentille centrale 31, mais qu'elle n'est, vue en coupe et dans le sens de l'épaisseur, qu'une fraction de tore puisqu'un tore est par définition engendré par un cercle se déplaçant autour d'un point qui lui est extérieur. La lentille semi-torique 32 a donc, comme cela sera montré sur la figure 7 une section dans un plan perpendiculaire au plan principal de la diode électroluminescente qui est une fraction de cercle.

A chacune des lentilles constituant le dispositif optique de la diode électroluminescente est associée une zone émissive: la zone émissive 41 correspondant à la lentille centrale circulaire 31 est elle-même une zone émissive circulaire, tandis que la zone émissive 42 correspondant à la lentille semi-torique 32 est elle-même une zone émissive en forme de ruban formant un cercle.

En ce qui concerne la densité d'occupation de la surface de la diode électroluminescente, si l'on prend un cas comparable avec celui de la figure 3, c'est-à-dire un rayon R égal à 50 µm, et un dispositif optique constitué par une lentille centrale 31 et une lentille concentrique 32, avec une garde de largeur g = 5 µm entre les deux lentilles, il s'ensuit que la lentille centrale 31 a un rayon de 15 µm et la lentille circulaire 32 a une largeur de 30 µm. De la même façon que précédemment un calcul élémentaire de surface des cercles permet de montrer que 93% de la surface disponible sur la diode est occupée par le dispositif optique.

De la même façon la totalité des aires émissives, c'est-à-dire l'aire émissive 41 au centre de la diode électroluminescente et l'anneau émissif 42, ou les anneaux s'il y a une pluralité de lentilles en demi-tore sur la diode, ont une surface totale beaucoup plus grande que dans le cas représenté dans les figures 2 et 3, c'est-à-dire des zones émissives localisées. Ceci permet de diminuer la densité d'injection de courant dans la diode et donc de limiter l'échauffement.

Bien entendu, la comparaison prise entre la diode des figures 2 et 3 et la diode selon l'invention de la figure 6 est prise pour de mêmes conditions de diamètre de diode ou de fibre optique, et ne préjuge en rien de la forme du dépôt de contact ohmique 7 en surface du corps de la diode ainsi que de la garde à respecter entre la métallisation 7 et la lentille semi-torique la plus externe du dispositif optique.

La figure 7 représente une vue de trois quarts dans l'espace d'une diode électroluminescente munie d'un dispositif optique selon l'invention. Cette vue permet de plus facilement mettre en évidence la structure, car elle apporte le relief qui manque à la figure 6.

Sur cette figure 7 le corps 1 de la diode n'est pas détaillé: il est bien entendu que ce corps comprend au moins un substrat, et au moins une couche active comprise entre deux couches de confinement, ainsi que les métallisations nécessaires à la mise sous tension de la diode. Seules ont été représentées les zones émissives 41, 42 et 43, puisque, à titre d'exemple non limitatif, la figure 7 représente une diode munie de deux lentilles semi-toriques. La zone émissive centrale 41 est un cercle, et les zones émissives 42 et 43 sont des anneaux.

La lentille centrale 31 et les deux lentilles semi-toriques 32 et 33 ont sur cette figure une section qui est sensiblement celle d'un demi-cercle. Il ne s'agit là que d'une forme de réalisation d'une diode munie du dispositif optique de l'invention car la convexité de la lentille centrale et des lentilles semi-toriques est définie par les conditions d'environnement, c'est-à-dire la distance entre une région émissive telle que 41 et la lentille qui lui est associée 31 d'une part, et la distance entre ladite lentille 31 et la fibre optique d'autre part. Par conséquent les lentilles composant le système selon l'invention peuvent avoir une courbure qui est limitée à une fraction de cercle, inférieure au demi-cercle.

Par ailleurs, le maximum d'efficacité du dispositif est obtenu pour des lentilles dont le diamètre, pour la lentille centrale 31, ou la largeur, pour les lentilles toriques 32 et 33, est environ quatre fois la largeur du ruban émetteur 41 ou 42. Les dimensions de l'optique de convergence sont également liées au rayon de courbure r de chacune des lentilles, ce rayon étant limité par l'épaisseur des couches épitaxiées que l'on peut réaliser actuellement, c'est-à-dire un maximum de 25 µm environ dans des matériaux du type Ga Al As, et dans des conditions aptes à faire une bonne optique.

Les avantages de ce type de structure optique sont:

– une grande compacité d'intégration par rapport à une structure comportant plusieurs petites lentilles circulaires,

– un diamètre total de la diode et de l'optique qu'elle porte en rapport avec celui du cœur des fibres optiques, la structure circulaire avec lentille circulaire et tore étant à ce point de vue supérieure à la structure comportant des lentilles demi-cylindriques,

– une structure à haut rendement optique en sortie, améliorant d'un facteur voisin de 3 la concentration des rayons lumineux issus des zones émissives de la diode électroluminescente pour les diriger vers une fibre optique,

– une amélioration des conditions de fonctionnement de la diode, puisqu'il y a augmentation de la surface des zones d'injection de courant, c'est-à-dire des zones émissives 41, 42, 43..., ce qui permet de travailler à densité plus faible et donc dans de meilleures conditions thermiques,

– une grande facilité de mise en œuvre par les techniques collectives d'usinage identiques à celles utilisées pour les lentilles circulaires des figures 1 et 2.

Les figures 8 et 9 permettent de rappeler et d'évoquer rapidement ce procédé de réalisation d'optique qui est connu. La figure 8 représente, très schématisé, le corps 1 d'une diode électroluminescente ainsi que les zones émissives 41 et 42. La structure de diode ayant déjà reçu les différentes couches de confinement, actives et autres couches dans le détail desquelles il n'est pas nécessaire de rentrer, puisqu'elles sont en dehors du domaine de l'invention, une couche épaisse 6 est déposée sur la surface de la diode opposée à celle du substrat. Cette couche épaisse 6 doit obligatoirement être réalisée en un matériau transparent à la longueur d'onde de la lumière émise par la diode: si la diode est à base de Ga As et Ga Al As, la couche 6 comportera obligatoirement de l'aluminium pour être transparente. Cette couche peut être réalisée par différentes techniques, certaines n'étant pas intéressantes du point de vue de la vitesse de réalisation et de l'économie, d'autres étant plus particulièrement recommandées comme l'épitaxie liquide ou l'épitaxie organométallique.

Sur la surface libre de la couche 6 est déposée une couche de résine de masquage qui est ensuite gravée de façon à donner une empreinte 51, qui correspond à la future lentille circulaire centrale 31, et au moins une empreinte en forme d'anneau 52, qui correspond à la future première lentille semi-torique 32.

La figure 9 représente l'étape suivante de réalisation de l'optique. Par chauffage dans des conditions bien contrôlées de la couche de résine, les îlots 51 et 52 de résine se déforment et, par les tensions capillaires et par fluage, ils donnent des îlots 61 et 62 qui ont désormais la forme d'une lentille circulaire pour l'îlot 61 et d'une lentille hémi-torique pour l'îlot 62.

Les îlots 61 et 62 ne constituent pas l'optique selon l'invention mais seulement les masques qui permettent de tailler le dispositif optique dans la couche de matériau semi-conducteur 6 par usinage ionique. En fait, la résine organique de masquage s'érode deux fois moins vite que le matériau semi-conducteur, sous les chocs des ions du faisceau ionique. La couche 6 de matériau cristallin est donc usinée avec une vitesse différente selon l'épaisseur du masque de résine qui se trouve déposé sur elle: lorsque l'usinage est terminé, la lentille centrale et la ou les lentilles semi-toriques 31 et 32 sont réalisées et elles ont été représentées sur cette figure 9 sous forme de pointillés dans la couche 6.

La description de l'invention a été faite en s'appuyant sur le cas où l'optique ne comporte qu'une ou deux lentilles semi-toriques: bien entendu il ne s'agit là que d'une simplification des figures mais l'invention s'applique au cas où une diode électroluminescente, couplée à un dispositif de taille plus importante qu'une fibre optique, comporte une pluralité de lentilles semi-toriques.

En outre, pour une question d'homogénéité les dessins représentent tous une diode électroluminescente de type à émission par la surface supérieure (top emitting) mais il est bien entendu que ce type d'optique s'adapte également à une diode «Burrus», dont le substrat est reconstitué par dessus la diode qui est désormais soudée sur son embase par les couches épitaxiées.

Enfin, la structure interne de la diode en temps que dispositif semi-conducteur ne limite pas la portée de l'invention qui concerne un système optique de concentration des rayons lumineux, en vue d'améliorer le rendement des diodes électroluminescentes existantes. L'invention est donc précisée par les revendications suivantes.

**Revendications**

1. Dispositif optique de concentration du rayonnement lumineux émis par une diode électroluminescente, comportant au moins une zone émissive (41) définie dans la couche active de ladite diode, une lentille hémisphérique (31), centrée par rapport à la zone émissive (41) et réalisé dans la couche de contact (6) qui supporte une métallisation (7) de prise de contact électrique et qui est en un matériau semi-conducteur transparent à la longueur d'onde du rayonnement émis par la diode, et au moins une lentille hémitorique (32) planconvexe, concentrique avec la lentille hémisphérique centrale (31).

2. Dispositif optique selon la revendication 1, caractérisé en ce qu'il comporte une pluralité de lentilles (31, 32, 33) concentriques, chaque lentille étant associée à une région (41) ou ruban en anneau (42, 43) de la zone émissive, les lentilles (31, 32, 33) ayant même rayon de courbure (r).

3. Dispositif optique selon la revendication 2, caractérisé en ce que le diamètre (2r) de la lentille centrale (31) et la largeur (2r) des lentilles concentriques (32, 33) est de l'ordre de quatre fois la largeur de la zone émissive (41, 42, 43) dont elle recueillent le rayonnement émis.

4. Dispositif optique selon la revendication 1, caractérisé en ce que, la diode électroluminescente étant réalisée en matériaux de la famille III–V, tels que l'arsenic et le gallium, la couche (6) dans laquelle est réalisée le dispositif optique (31, 32) est un composé ternaire d'arsenic, de gallium et d'aluminium.

5. Diode électroluminescente du type à émission «par la face supérieure», caractérisée en ce qu'un dispositif optique (31, 32) selon l'une quelconque des revendications 1 à 4 est réalisé sur la face supérieure, opposée à celle du substrat de la diode électroluminescente.

6. Diode électroluminescente du type «Burrus», caractérisée en ce qu'un dispositif optique (31, 32) selon l'une des revendications 1 à 4 est réalisé dans une couche comprise entre la couche active et le substrat de la diode électroluminescente, le rayonnement lumineux étant émis à travers un trou pratiqué dans ledit substrat.

**Patentansprüche**

1. Optische Vorrichtung zur Konzentration von Lichtstrahlung, die von einer Leuchtdiode ausgeht, mit wenigstens einer emittierenden Zone (41), die in der aktiven Schicht der genannten Diode begrenzt ist, einer halbkugelförmigen Linse (31), die in bezug auf die emittierende Zone (41) zentriert und in der Kontaktschicht (6) verwirklicht ist, welche eine Metallisierung (7) zur elektrischen Kontaktierung trägt, sowie aus einem Halbleitermaterial besteht, das bei der Wellenlänge der von der Diode ausgesendeten Strahlung durchlässig ist, und wenigstens einer halbringförmigen plankonvexen Linse (32), die konzentrisch zu der zentralen halbkugelförmigen Linse (31) ist.

2. Optische Vorrichtung nach Anspruch 1, dadurch gekennzeichnet, daß sie mehrere konzentrische Linsen (31, 32, 33) umfaßt, wobei jede Linse einem Bereich (41) oder Streifen der emittierenden Zone in Ringform (42, 43) zugeordnet ist, wobei diese Linsen (31, 32, 33) denselben Krümmungsradius (r) aufweisen.

3. Optische Vorrichtung nach Anspruch 2, dadurch gekennzeichnet, daß der Durchmesser (2r) der zentralen Linse (31) und die Breite (2r) der konzentrischen Linsen (32, 33) die Größenordnung des Vierfachen der Breite der emittierenden Zone (41, 42, 43) aufweisen, wovon sie die emittierte Strahlung aufnehmen.

4. Optische Vorrichtung nach Anspruch 1, dadurch gekennzeichnet, daß, bei einer Leuchtdiode, die aus Stoffen der Familie III–V wie Arsen und Gallium verwirklicht ist, die Schicht (6), worin die optische Vorrichtung (31, 32) verwirklicht ist, eine ternäre Arsen-, Gallium- und Aluminium-Verbindung ist.

5. Leuchtdiode vom Typ mit Emission «an der oberen Seite», dadurch gekennzeichnet, daß eine optische Vorrichtung (31, 32) nach einem der Ansprüche 1 bis 4 an der oberen Fläche verwirklicht ist, welche der des Substrats der Leuchtdiode gegenüberliegt.

6. Leuchtdiode vom Typ «Burrus», dadurch gekennzeichnet, daß eine optische Vorrichtung (31, 32) nach einem der Ansprüche 1 bis 4 in einer Schicht verwirklicht ist, welche zwischen der aktiven Schicht und dem Substrat der Leuchtdiode liegt, wobei die Lichtstrahlung durch ein Loch hindurch ausgesendet wird, das in dem genannten Substrat angebracht ist.

## Claims

1. An optical device for the concentration of luminous radiation emitted by a light emitting diode, comprising at least one emissive zone (41) defined in the active layer of the said diode, a hemispherical lens (31), centered in relation to the emissive zone (41), produced in the contact layer (6) which carries a metallized layer (7) for making electrical contact and which is of a semiconducting material transparent at the wavelength of the radiation emitted by the diode, and at least one planoconvex hemitoroidal lens (32) concentric to the central hemispherical lens (31).

2. The optical device as claimed in claim 1 characterized in that it comprises a plurality of concentric lenses (31, 32 and 33), each lens being associated with a region (41) or stripe (42 and 43) with an annular form of the emissive zone, the lenses (31, 32 and 33) having the same radius (r) of curvature.

3. The optical device as claimed in claim 2 characterized in that the diameter (2r) of the central lens (31) and the width (2r) of the concentric lenses (32 and 33) is of the order of four times the width of the emissive zone (41, 42 and 43) whose emitted radiation they receive.

4. The optical device as claimed in claim 1 characterized in that, the light emitting diode being produced from materials of the III–V group such as arsenic or gallium, the layer (6) in which the optical device (31 and 32) is produced is a ternary compound of arsenic, gallium and aluminum.

5. A light emitting diode of the "external surface" emission type characterized in that an optical device (31 and 32) according to any one of the preceding claims 1 through 4 is produced on the upper surface, opposite to that of the substrate of the light emitting diode.

6. A light emitting diode of the "Burrus" type characterized in that an optical device (31 and 32) in accordance with any one of the claims 1 through 4 is produced in a layer comprised between the active layer and the substrate of the light emitting diode, the luminous radiation being emitted through a hole produced in the said substrate.

# FIG.1

# FIG. 2

# FIG. 3

# FIG.4

# FIG.5

FIG.6

FIG.7

FIG.8

FIG.9

11